Europäisches Patentamt

(19) European Patent Office

Office européen des brevets

(11) Publication number : 0 498 677 A2

# (12) EUROPEAN PATENT APPLICATION

(21) Application number : 92301072.2

(22) Date of filing : 07.02.92

(51) Int. Cl.⁵ : H05K 3/46, H05K 1/00

(30) Priority : 08.02.91 JP 39363/91

(43) Date of publication of application :
12.08.92 Bulletin 92/33

(84) Designated Contracting States :
AT BE CH DE DK ES FR GB GR IT LI LU NL PT
SE

(71) Applicant : GRAPHICO CO. LTD.
11-14, Higashikanda 1-chome
Chiyoda-ku, Tokyo 101 (JP)

(72) Inventor : Takashima, Rihei
256-2, Kataishi, Hirooka
Shiojiri-city, Nagano, 399-07 (JP)

(74) Representative : Skone James, Robert
Edmund
GILL JENNINGS & EVERY 53-64 Chancery
Lane
London WC2A 1HN (GB)

(54) Improvement in or relating to a printed-circuit board.

(57) Disclosed is an improved printed-circuit board comprising upper and lower dielectric boards (10) and (11) each having a signal conductor pattern (12) or (13) on one side, and a porous dielectric board (15) sandwiched between the upper and lower dielectric boards (10) and (11). Preferably porous boards (15) have through holes regularly arranged therein. The apparent dielectric constant of the porous dielectric board (15) is such a reduced value that the upper limit of signal frequency is expanded without recourse of reducing the signal conductor width. Advantageously printed-circuit boards according to the present invention can be used as data bus in transferring data at a high-speed in a computer system.

Fig·1

The present invention relates to an improvement in or relating to a printed-circuit board, particularly printed-data bus boards suitable for use in transferring data at a high-speed in a computer system.

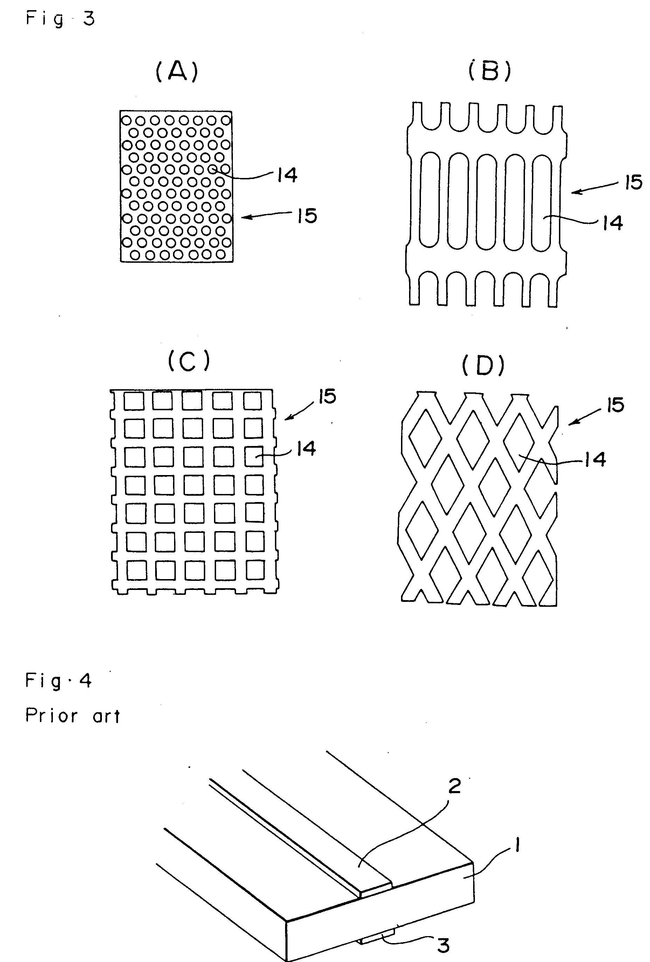

Fig.4 shows a conventional printed-data bus board to provide a super-high frequency transmission line for use in a computer system. As shown in the drawing, it comprises a dielectric board 1 having a pair of signal conductors 2 and 3 printed on both sides to provide a transmission line.

The dielectric board 1 is appropriate for the purpose of electrically isolating the opposite conductors 2 and 3 and of holding these conductors at a predetermined interval. If the dielectric constant of the dielectric board 1 is large, the speed of the travelling wave on the transmission line will decrease, and accordingly the wave length of the travelling wave on the transmission line will be shorter than that of the electromagnetic wave radiated in free space. If a high-frequency signal is transmitted on a transmission line whose dielectric board has an increased dielectric constant, it is necessary to use signal conductor lines of possible minimum width. To meet this demand the accuracy with which such thinnest conductor lines are printed on a dielectric board must be increased to the limit. In any event the upper limit of signal frequency will be limited by the dielectric constant of the dielectric board material which is used in a printed-circuit board, and the difficulty with which signal conductor patterns are printed on dielectric boards will increase with the increase of signal frequency.

This problem will be increasingly serious when such printed-circuit boards are used as data bus in transferring data over an elongated length at high speed.

One object of the present invention is to provide a printed-circuit board which includes a dielectric board whose dielectric constant is small enough to provide a printed-circuit board guaranteed free of such defects as described above.

To attain this object a printed-circuit board according to the present invention comprises upper and lower dielectric boards each having a signal conductor pattern on one side, and a porous dielectric board sandwiched between the upper and lower dielectric boards with the signal conductor pattern of the upper dielectric board facing the signal conductor pattern of the lower dielectric board to provide a transmission line.

The porous dielectric board has numerous through holes, the dielectric constant each of which through holes is about 1, and therefore the apparent dielectric constant of the porous dielectric board is much smaller than the dielectric constant of the solid dielectric board, thus permitting the expanding of the upper limit of the frequency range for the transmission line on the printed-circuit board without recourse of reducing the width of printed signal conductors. This facilitates the printing of such signal conductors or signal conductor patterns.

Other objects and advantages of the present invention will be understood from the following description of printed-circuit boards according to preferred embodiments of the present invention, which are shown in accompanying drawings:

Fig.1 is a perspective view of a printed-circuit board according to a preferred embodiment of the present invention;

Fig. 2 is a cross section of the printed-circuit board of Fig.1;

Figs.3A to 3D show examples of porous dielectric board; and

Fig.4 is a perspective view of a conventional printed-circuit board.

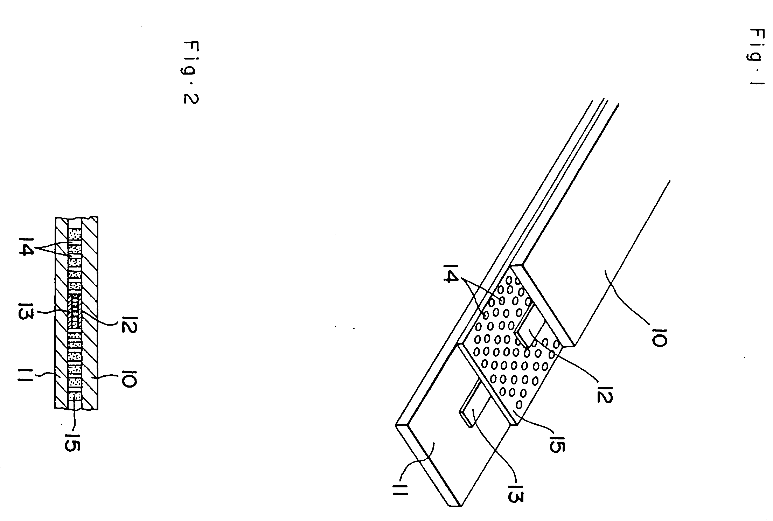

Figs.1 and 2 show a printed-circuit board according to one embodiment of the present invention. It comprises upper and lower dielectric boards 10 and 11 each having a signal conductor pattern 12 or 13 on one side, and a porous dielectric board 15 sandwiched between the upper and lower dielectric boards 10 and 11 with the signal pattern 12 of the upper dielectric board 10 facing the signal pattern 13 of the lower dielectric board 11 to provide a transmission line. The porous dielectric board 15 has numerous small apertures 14, and is bonded to the upper and lower dielectric boards 10 and 11. The porous dielectric board 15 may be made by making numerous small holes 14 in a sheet material such as prepreg sheet ( glass cloth or any other carrier impregnated with resin and cured upto Stage B) by a punching machine or may be made of sponge.

Figs.3A to 3D show different hole shapes such as circle, ellipse, square and rhombus. Hole size may be determined as desired. Preferably, holes are arranged regularly as shown in the drawing. The regular arrangement of holes 14 will provide a dielectric board of even dielectric constant. Holes can be made by punching machine, preferably sequentially feeding-and-punching machine.

The apparent dielectric constant of a porous dielectric board depends on the porosity of the board, that is, the total area of holes per unit area. Therefore, dielectric boards having a desired dielectric constant can be made by controlling the porosity of the board in punching. The degree of sheet strength ( physical strength ) which is reduced by making through holes in the board can be compensated by using upper and lower dielectric boards of increased rigidity.

When a printed-circuit board of Fig.1 is used as a data bus in transferring data at a high-speed in a computer system, it may be modified by printing transmission lines each comprising a pair of signal conductors 12 and 13 as many as required.

As may be understood from the above, porous dielectric boards 15 have holes 14 each filled with air, the dielectric constant of which is about 1. Therefore, dielectric boards of an increased dielectric constant can have an apparently reduced dielectric constant. The use of such porous dielectric boards permits the rising or expanding of the upper signal frequency limit without recourse of reducing the signal conductor width. Elongated signal conductors or signal conductor patterns can be made with ease.

**Claims**

1. A printed-circuit board comprising upper and lower dielectric boards (10,11) each having a signal conductor pattern (12,13) on one side, and a porous dielectric board (15) sandwiched between the upper and lower dielectric boards (10,11) with the signal conductor pattern (12) of the upper dielectric board (10) facing the signal conductor pattern (13) of the lower dielectric board (11) to provide a transmission line.

2. A printed-circuit board according to claim 1 wherein the porous dielectric board (15) is a prepreg sheet.

3. A printed-circuit board according to claim 1 or 2 wherein the porous dielectric board (15) has a plurality of through holes (14) regularly arranged.

4. A printed-circuit board according to claim 1 wherein the porous dielectric board (15) is made of sponge.

Fig·1

Fig·2

Fig 3

(A)

14

15

(B)

15

14

(C)

15

14

(D)

15

14

Fig·4

Prior art

2

1

3